# EUROPEAN PATENT APPLICATION

(11) **EP 2 400 558 A1**
(43) Date of publication of application: **28.12.2011**
(21) Application number: 10743807.9
(22) Date of filing: 18.02.2010
(51) Int. Cl.: H01L 31/04, H01L 21/203

(54) **LIGHT ABSORBING MATERIAL AND PHOTOELECTRIC CONVERSION ELEMENT USING SAME**

(30) Priority: 20.02.2009 JP 2009038224
(71) Applicant: National University Corporation Kyoto Institute of Technology, Sakyo-ku Kyoto-shi, Kyoto 606-8585 (JP)
(72) Inventor: SONODA, Saki, Kyoto-shi Kyoto 606-8585 (JP); YOSHIMOTO, Masahiro, Kyoto-shi Kyoto 606-8585 (JP)
(74) Representative: HOFFMANN EITLE
(86) International application number: PCT/JP2010/052439
(87) International publication number: WO 2010/095681

(57) **Abstract**

There is provided a new light-absorbing material and a photoelectric conversion element using the same, which are capable of improving conversion efficiency of a solar cell. The light-absorbing material in the present invention is made up of a GaN-based compound semiconductor with part of Ga replaced by a 3d transition metal, and has one or more impurity bands, and whose light absorption coefficient over an overall wavelength region of not longer than 1500 nm and not shorter than 300 nm is not lower than 1000 cm⁻¹.

## Description

### Technical Field

The present invention relates to a light-absorbing material having a multiband structure, and a photoelectric conversion element using the same.

### Background Art

In recent years, against a backdrop of a global environmental problem such as a CO₂ emission problem, an energy cost problem such as a rise in crude oil price, and the like, an expectation has been increasing to a solar cell using sunlight which is clean and inexhaustible. A solar cell mainly used at present is a single junction solar cell made up of one pn-junction element using monocrystal silicon or polycrystal silicon as a semiconductor. A theoretical conversion efficiency (percentage of convertibility of incident energy to electric energy) of this single junction solar cell is said to be on the order of 28%, but on a practical level, for example in the case of a monocrystal silicon solar cell, the efficiency is typically from 15% to 17%.

The semiconductor such as silicon which is used for the solar cell has a specific band gap, and when the semiconductor absorbs light energy corresponding to its band gap, electrons in a valence band are excited to a conduction band, while holes are generated in the valence band, and these electrons and holes are accelerated by an internal field formed by the pn-junction and flow as a current to the outside, thereby generating an electromotive force. At that time, light with lower energy than the band gap transmits through the semiconductor without being absorbed (transmission loss). Further, although light with higher energy than the band gap is absorbed, most of the energy is wasted as heat (heat energy loss). Accordingly, if light in an unused wavelength region of sunlight can be utilized, the conversion efficiency of the solar cell can be significantly improved.

As methods for utilizing light in an unused wavelength region of sunlight, there have been proposed a method of using a multijunction solar cell formed by laminating a plurality of pn-junction elements having different band gaps, such as a solar cell with a tandem structure (e.g. Nonpatent Document 1), and a method of using a single junction solar cell using a multiband structure where an intermediate band such as an impurity band is introduced into a band gap of a semiconductor and absorbs long-wavelength light, which is normally not absorbable, through use of the intermediate band (e.g. Patent Document 1, Nonpatent Document 2).

In the case of using the multijunction solar cell, a plurality of elements are laminated so as to make the band gap smaller sequentially from the light incident side, and shorter-wavelength light is used to generate electric power in the incident-side element while longer-wavelength light is used to generate electric power in the lower-layered element. This enables the use of light in a broad wavelength region of sunlight, thereby reducing the transmission loss due to long-wavelength light and the heat energy loss due to short-wavelength light, and theoretically, a conversion efficiency of not lower than 60% can be expected. However, with the solar cell basically having a structure in which the elements are connected in a vertical and serial manner, there has been a problem in that a current amount of an entire cell decreases when the electric power generation efficiency deteriorates even in any one layer among the respective layers and a current thus decreases. For example, even if a solar cell having the tandem structure optimally designed based on ideal sunlight with AM-1.5 (sunlight spectrum on the earth's surface) is used, there is generally a little light with a wavelength in the vicinity of red on a cloudy day, and hence the electric power generation efficiency of the element aimed at the light in the vicinity of red decreases extremely. There has thus been a problem with the tandem type solar cell in that its ability can be sufficiently exerted only on a sunny day. There has further been a problem in that, although the multijunction type involves lamination of materials with different lattice constants, it is difficult to ensure lattice matching. For that reason, a three-junction type using compound semiconductors of GalnP/GaAs/InGaAs has only gained a conversion efficiency of about 33%.

On the other hand, in the single junction solar cell using the multiband structure, high conversion efficiency can be expected since an electron hole pair is generated both in light absorption on two or more stages through the intermediate band and in light absorption by means of a band gap of a base semiconductor. As these examples, for example, there are proposed one using a Zn_{1-y}Mn_{y}OₓTe₁₋ₓ alloy (Patent Document 1), and one using a quantum dot superlattice structure in an interlayer between a p-layer and an n-layer (Nonpatent Document 2). According to the method of Patent Document 1, it is confirmed that addition of oxygen to the ZnMnTe alloy leads to formation of a new intermediate band. This is said to allow enhancement of matching with a spectrum of sunlight, and thus theoretically allow expectation of a conversion efficiency of not lower than 50% even in the single junction type. However, subsequently to ion-planting of oxygen, melting by use of a pulse laser is necessary, and a complicated manufacturing process has thus been a major problem. Meanwhile, in the method of Nonpatent Document 2, an absorption wavelength can be selected by controlling a size of a quantum dot, so as to expect enhancement in matching with the spectrum of sunlight, and further, with electron energy relaxation time being slower in the quantum dot than in a bulk crystal, the electrons may be taken out to the outside before occurrence of energy relaxation due to phonon emission. Moreover, it is said that with the superlattice structure formed, the intermediate band is formed by coupling between the quantum dots, which may allow absorption of light with a plurality of wavelengths. However, a conversion efficiency of only the order of 30% is actually obtained.

On the other hand, as a light-absorbing material for heat utilization of sunlight, a material which is two-dimensionally arranged and has a periodical surface fine rugged pattern is described in Patent Document 2, but this material is difficult to manufacture since formation of a regular rugged array is required.

As for a band structure of a compound concerning the present invention in which part of Ga in GaN is replaced by a 3d-transition metal element, it is reported in a document that an energy level is formed between the valence band and the conduction band, and energy levels in compounds with part of Ga in GaN replaced by 3d-transition metal elements Sc, Ti, V, Cr, Mn, Fe, Co, Ni, or Cu are respectively obtained by calculation (Nonpatent Document 3). However, the use of the compound as the photoelectric material is not proposed. Further, it is reported that in a light absorption spectrum of GaN added with the order of 10²⁰/cm⁻³ (the order of 0.1%) of Mn, a light absorption peak exists at about 1.5 eV (Nonpatent Document 4). However, with an added amount of Mn being small, performance as the light-absorbing material is low, and for example, as for a light absorption coefficient in a wavelength band of 300 to 1500 nm with high sunlight radiation intensity which is important for obtaining high electric power generation efficiency as a photoelectric conversion element for sunlight electric power generation, only a minimal value as small as the order of 600 to 700 cm⁻¹ can be realized. In order to obtain high conversion efficiency in the solar cell, the light absorption coefficient in the wavelength band of 300 to 1500 nm is desired to be higher.

### Citation List

· Patent Document 1:JP-A No.2007-535129
· Patent Document 2:JP-A No.2003-332607
· Nonpatent Document 1: Phys. Rev. Lett., 91, 246403 (2003)
· Nonpatent Document 2: Phys. Rev. Lett., 78, 5014 (1997)
· Nonpatent Document 3: Phys. Rev. B 66, 041203 (2002)
· Nonpatent Document 4: Appl. Phys. Lett., 81 5159 (2002)

### Summary of Invention

### Technical Problem

As thus described, although the attempts have hitherto been made to use light in an unused wavelength region of sunlight so as to improve conversion efficiency of a solar cell, a practically usable technique has not been found under the present circumstances.

Accordingly, an object of the present invention is to provide a new light-absorbing material and a photoelectric conversion element using the same, which are capable of improving conversion efficiency of a solar cell.

### Solution to Problem

The present inventors conducted dedicated studies for solving the above problems, and consequently completed the present invention by finding that, when part of Ga in GaN in a GaN-based compound semiconductor having an impurity band is replaced by 3d-transition metals Sc, Ti, V, Cr, Mn, Fe, Co, Ni, or Cu in a fixed amount or more, a light absorption coefficient in a wavelength region including ultraviolet rays to infrared rays, namely a wavelength region of not longer than 1500 nm and not shorter than 300 nm is not lower than 1000 cm⁻¹.

That is, a light-absorbing material in the present invention is characterized by comprising a GaN-based compound semiconductor with part of Ga replaced by at least one kind of 3d transition metals in a fixed amount or more, and having one or more impurity bands between a valence band and a conduction band, and a light absorption coefficient over an overall wavelength region of not longer than 1500 nm and not shorter than 300 nm is not lower than 1000 cm⁻¹. The light-absorbing material in the present invention can be suitably used as a photoelectric conversion material.

In the present invention, Ga₁₋ₓMnₓN, (0.02 ≤ x ≤ 0.3) can be used as the above compound semiconductor.

Further, another light-absorbing material in the present invention is characterized by comprising a GaN-based compound semiconductor with part of Ga replaced by at least one kind of 3d transition metals, and with an acceptor dopant and/or a donor dopant doped thereinto, and having one or more impurity bands, and a light absorption coefficient over an overall wavelength region of not longer than 1500 nm and not shorter than 300 nm is not lower than 1000 cm⁻¹.

Further, as the above compound semiconductor, a compound semiconductor can be used in which the acceptor dopant is Mg, and which is represented by a general formula Ga_{1-x-z}MnₓMg_{z}N (0.02 ≤ x ≤ 0.3, 0 < z ≤ 0.125).

Further, as the above compound semiconductor, a compound semiconductor can be used in which the donor dopant is a hydrogen atom, and which is represented by a general formula Ga₁₋ₓMnₓN : H_{y} (0.02 ≤ x ≤ 0.3, 0 < y < x).

Further, as the above compound semiconductor, a compound semiconductor can be used in which the acceptor dopant and the donor dopant are respectively Mg and H, and which is represented by a general formula Ga_{1-x-z}MnₓMg_{z}N : H_{y} (0.02 ≤ x ≤ 0.3, 0 < z ≤ 0.125, 0 < y - z < x in the case of y > z, and 0 < y ≤ z in the case of y ≤ z).

A photoelectric conversion element can be configured using the light-absorbing material in the present invention. That is, the photoelectric conversion element in the present invention is a photoelectric conversion element comprising a photoelectric conversion layer comprising at least one pn-junction or pin-junction formed by a plurality of compound semiconductor layers, **characterized in that** at least one layer of the plurality of compound semiconductor layers is formed by use of a light-absorbing material comprising a GaN-based compound semiconductor with part of Ga replaced by at least one kind of 3d transition metals, and has one or more impurity bands between a valence band and a conduction band, and whose light absorption coefficient over an overall wavelength region of not longer than 1500 nm and not shorter than 300 nm is not lower than 1000 cm⁻¹.

Further, as the above compound semiconductor, Ga₁₋ₓMnₓN (0.02 ≤ x ≤ 0.3) can be used.

Further, another photoelectric conversion element in the present invention is a photoelectric conversion element comprising a photoelectric conversion layer comprising at least one pn-junction or pin-junction formed by a plurality of compound semiconductor layers, **characterized in that** at least one layer of the plurality of compound semiconductor layers is formed by use of a light-absorbing material comprising a GaN-based compound semiconductor with part of Ga replaced by at least one kind of 3d transition metals, and with an acceptor dopant and/or a donor dopant doped thereinto, and has one or more impurity bands between a valence band and a conduction band, and whose light absorption coefficient over an overall wavelength region of not longer than 1500 nm and not shorter than 300 nm is not lower than 1000 cm⁻¹.

Further, as the above compound semiconductor, a compound semiconductor can be used which is doped with the acceptor dopant being Mg, and represented by a general formula Ga_{1-x-z}MnₓMg_{z}N (0.02 ≤ x ≤ 0.3, 0 < z ≤ 0.125).

Further, as the above compound semiconductor, a compound semiconductor can be used which is doped with the donor dopant being a hydrogen atom, and represented by a general formula Ga₁₋ₓMnₓN : H_{y} (0.02 ≤ x ≤ 0.3, 0 < y < x).

Further, as the above compound semiconductor, a compound semiconductor can be used which is doped with the acceptor dopant and the donor dopant being respectively Mg and H, and is represented by a general formula Ga_{1-x-z}MnₓMg_{z}N : H_{y} (0.02 ≤ x ≤ 0.3, 0 < z ≤ 0.125, 0 < y - z < x in the case of y > z, and 0 < y ≤ z in the case of y ≤ z).

Further, for the photoelectric conversion element in the present invention, a GaN-based compound semiconductor having a rugged structure formed on a surface and/or an interface thereof can be used.

### Advantageous Effects of Invention

The GaN-based compound semiconductor in the present invention is one in which part of Ga is replaced by at least one kind of 3d transition metals selected from the group consisting of Sc, Ti, V, Cr, Mn, Fe, Co, Ni, and Cu, or one in which part of Ga is replaced by at least one kind of 3d transition metals, and an acceptor dopant and/or a donor dopant are doped. Since the GaN-based compound semiconductor in the present invention has the impurity band in the band gap of GaN, it can absorb light in a visible-light region which is not absorbable in GaN, and further, light in an infrared-ray region. That is, light in an ultraviolet region of not shorter than 300 nm to light in the infrared region of not longer than 1500 nm can be absorbed with high efficiency of not lower than 1000cm⁻¹. Moreover, a large value of not lower than 3000 cm⁻¹ is indicated as the light absorption coefficient in the wavelength region of 300 nm to 1100 nm. That is, excitation is generated from the valence band to conduction band due to excitation through the impurity band, allowing utilization of sunlight with a wavelength which is not usable in GaN, thereby improving the conversion efficiency. Moreover, since a replacement amount of at least one kind of 3d transition metals selected from the group consisting of Sc, Ti, V, Cr, Mn, Fe, Co, Ni, and Cu, which replaces part of Ga is a fixed amount or more, a higher light absorption coefficient than that of the GaMnN-based semiconductor compound reported in Nonpatent Document 4 can be obtained.

Furthermore, since the GaN-based compound semiconductor in the present invention is produced at a high temperature of 300°C to 1000°C, it is excellent in thermal stability and can be sufficiently used for a light-concentrating type solar cell in which a cell temperature becomes high. Further, the GaN-based compound semiconductor in the present invention does not use a highly toxic element such as As or Cd, as in a GaAs-based or CdTe-based compound semiconductor solar cell, thereby allowing provision of a solar cell with a small environmental load. Moreover, since a rare metal such as In is not used, a solar cell can be manufactured at lower cost.

Further, since the light-absorbing material in the present invention can absorb sunlight in a broad wavelength region, it is also useful for heat utilization of sunlight, and as a material for a light-absorbing element such as an optical filter that absorbs light in a broad range of a wavelength band.

### Brief Description of Drawings

FIG. 1 is a schematic view showing a band structure of one photoelectric conversion element in the present invention.
FIG. 2 is a schematic view showing a band structure in an operating state of the photoelectric conversion element of FIG. 1 .
FIG. 3 is a schematic view showing a band structure of another photoelectric conversion element in the present invention.
FIG. 4 is a schematic sectional view showing an example of a structure of the photoelectric conversion element in the present invention.
FIG. 5 is a schematic view showing a configuration of an MBE device used for producing a light-absorbing material in the present invention.
FIG. 6 is an x-ray diffraction pattern of a light-absorbing material in Example 1.
FIG. 7 is a light absorption spectrum of the light-absorbing material in Example 1.
FIG. 8 is a graph showing a photocurrent characteristic of the light-absorbing material in Example 1.
FIG. 9 is a graph showing a photocurrent characteristic of a light-absorbing material in Example 2.
FIG. 10 is a graph showing a photocurrent characteristic of a light-absorbing material in Example 3.
FIG. 11 is a light absorption spectrum of a light-absorbing material in Example 4.
FIG. 12 is a graph showing a photocurrent characteristic of the light-absorbing material in Example 4.
FIGS. 13A to 13C are AFM photographs and graphs showing measurement results of surface roughness of a light-absorbing material in Example 5, where 13A shows a result of Sample 1, 13B shows a result of Sample 2, and 13C shows a result of Sample 3.
FIGS. 14A to 14C are graphs showing photocurrent characteristics of the light-absorbing material in Example 5, where 14A shows a result of Sample 1, 14B shows a result of Sample 2, and 14C shows a result of Sample 3.
FIG. 15 is a schematic view showing a structure of a photoelectric conversion element in Example 6.
FIG. 16 is a graph showing a relation between light irradiation and a photocurrent in Example 6.
FIG. 17 is a light absorption spectrum of a sample with its 3d-transition metal being V and x = 0.056 in Example 7.
FIG. 18 is a light absorption spectrum of a sample with its 3d-transition metal being Cr and x = 0.088 in Example 7.
FIG. 19 is a light absorption spectrum of a sample with its 3d-transition metal being Co and x = 0.052 or x = 0.128 in Example 7.
FIG. 20 is a light absorption spectrum of a sample with its 3d-transition metal being Mn and x = 0.2 in Example 7.

### Description of Reference Signs

- 1: single-crystal sapphire substrate
- 2: n-GaN layer
- 3: p-GaMnN layer
- 4, 5: electrode
- 11: single-crystal sapphire substrate
- 12: p-GaN layer
- 13: GaMnN layer
- 14: n-GaN layer
- 15, 16: electrode
- 20: substrate holder
- 21: substrate
- 22: vacuum chamber
- 23: liquid nitrogen shroud
- 24: first vapor deposition source
- 25: second vapor deposition source
- 26: gas introduction nozzle
- 27: RHEED screen
- 28: gas source
- 29: heater

### Description of Embodiments

Hereinafter, the present invention will be described in detail with reference to the drawings and the like.

One light-absorbing material in the present invention is one characterized by being made up of a GaN-based compound semiconductor with part of Ga replaced by at least one kind of 3d transition metals, and having one or more impurity bands between a valence band and a conduction band, and **characterized in that** a light absorption coefficient over an overall wavelength region of not longer than 1500 nm and not shorter than 300 nm is not lower than 1000 cm⁻¹.

A compound semiconductor represented by a general formula Ga₁₋ₓTₓN (T represents a 3d-transition metal) is a compound semiconductor having a composition in which part of Ga atom in GaN is replaced by at least one kind of 3d transition metals selected from the group consisting of Sc, Ti, V, Cr, Mn, Fe, Co, Ni, and Cu. GaN is a semiconductor having a band gap of 3.4 eV (equivalent of a light wavelength of 365 nm) and not absorbing visible light, and even when it is irradiated with visible light, a photocurrent is not generated. Although Ga₁₋ₓTₓN in the present invention depends on a manufacturing method and manufacturing conditions, it has a wurtzite type structure, being the same as the structure of GaN, when produced by a Molecular Beam Epitaxy method(MBE method), and it has a structure like a microcrystal or amorphous with low crystallinity when produced by a sputtering method. However, the structure can be a crystal structure, a microcrystal structure, or an amorphous structure depending on a substrate temperature or a film formation method. Further, in the state of holding the band structure of GaN, the impurity band formed by the 3d-transition metal as the replacement is provided in the band gap. It is to be noted that in the present invention, to replace part of Ga by a 3d-transition metal means to be able to replace Ga by a 3d-transition metal within a range where the 3d-transition metal as the replacement can form the impurity band.

As for the 3d-transition metal, one or more kinds of metals are used which are selected from the group consisting of Sc, Ti, V, Cr, Mn, Fe, Co, Ni, and Cu. More preferably, Mn is used. The band mainly composed of a 3d-orbital of the transition metal can form the impurity band in the band gap of GaN without overlapping with the valence band and the conduction band. Herein, an element particularly preferable for formation of the impurity band as the 3d-transition metal is Mn, and an intermediate band is formed in a forbidden band at a position of 1.4 eV from the top of the valence band. Further, even by use of two or more kinds of 3d-transition metals, the impurity bands corresponding to those kinds of metals can be formed, and hence two or more impurity bands can be formed. Herein, Sc, Ti, V, Cr, Mn, Fe, Co, Ni, and Cu respectively have electron configurations of 3d4s², 3d²4s², 3d³4s², 3d⁵4s, 3d⁵4s², 3d⁶4s², 3d⁷4s², 3d⁸4s² and 3d¹⁰4s. The 3d-transition metal has not more than two 4s-electrons in an outermost shell which form crystal bonds. Meanwhile, since one electron is short in replacement of trivalent Ga by the 3d-transition metal, one 3d-electron is used. This brings the impurity band capable of accommodating five d-electrons into an unoccupied state. When the impurity band comes into the unoccupied state, light can be absorbed on two or more stages through the impurity band, other than by direct transition from the valence band to the conduction band of GaN, so that high conversion efficiency can be expected. In particular, Mn is preferred for its high probability of carrier transition by irradiation with light since Mn has good balance between the unoccupied state of the impurity band and a ground state of the electrons, as described above.

The GaN-based compound semiconductor containing Mn can be represented by a general formula Ga₁₋ₓMnₓN, where 0.02 ≤ x ≤ 0.3. The range of x is more preferably 0.05 ≤ x ≤ 0.25, and further more preferably 0.05 ≤ x ≤ 0.20. When x is smaller than 0.02, an impurity band sufficient for being able to efficiently perform carrier transition by irradiation with light is not generated, and when x is larger than 0.3, the impurity band, the valence band, and the conduction band overlap, and the impurity band is not formed therebetween. Herein, in the present invention, that an impurity band sufficient for being able to efficiently perform carrier transition by irradiation with light is not formed means that the light absorption coefficient in the wavelength band of 300 to 1500 nm is lower than 1000 cm⁻¹. Moreover, when x is larger than 0.3, the impurity band having a sufficient density is not formed, and hence the light absorption coefficient in the wavelength region of 300 to 1500 nm is lower than 1000 cm⁻¹.

Further, another light-absorbing material in the present invention is one characterized by being made up of a GaN-based compound semiconductor with part of Ga replaced by at least one kind of 3d transition metals and with an acceptor dopant and/or a donor dopant doped thereinto, and **characterized in that** a light absorption coefficient at least in a wavelength region of 300 to 1500 nm is not lower than 1000 cm⁻¹. Herein, the 3d-transition metals are metals with atomic numbers of 21 to 29, which are Sc, Ti, V, Cr, Mn, Fe, Co, Ni, and Cu. More preferable ones are V, Cr, Co and Mn. A further preferable one is Mn.

The acceptor dopant normally receives an electron from a base material (GaN) to generate a hole in the valence band, however, in the present invention, electrons are taken out of the impurity band derived from the 3d orbital to allow formation of the unoccupied state in the impurity band. It is thereby possible to enhance the photoelectric conversion efficiency. Examples of this acceptor dopant may include Mg, Ca, and C, among which Mg is particularly preferable. Although the GaN-based compound semiconductor doped with Mg is not particularly restricted, GaN-based compound semiconductor containing Mn is preferably used. This is because a favorable crystal can be obtained in combination of Mn and Mg. A material obtained by doping Mg into the GaN-based compound semiconductor containing Mn can be represented by a general formula Ga_{1-x-z}MnₓMg_{z}N (0.02 ≤ x ≤ 0.3, 0 < z ≤ 0.125). A more preferable range of x is 0.05 ≤ x ≤ 0.3. Herein, when z is larger than 0.125, Mn becomes resistant to formation of a solid solution, which is not preferable.

Moreover, the donor dopant normally gives an electron to the base material (GaN) to generate an electron as a carrier in the conduction band, however, in the present invention, the electron released from the donor dopant enters into the unoccupied portion of the impurity band. It is thereby possible to enhance the photoelectric conversion efficiency. Examples of this donor dopant may include H (hydrogen atom), Si, and O (oxygen atom), among which H is particularly preferable. A material obtained by doping H into the GaN-based compound semiconductor containing Mn can be represented by a general formula Ga₁₋ₓMnₓN H_{y}(0.02 ≤ x ≤ 0.3, 0 < y < x). This is because the impurity band is fully occupied when y is not smaller than x, and absorption on two or more stages does not occur. A more preferable range of x is 0.05 ≤ x ≤ 0.3.

Furthermore, these acceptor dopant and donor dopant may coexist in Ga₁₋ₓMnₓN. At this time, a general formula can be represented by Ga_{1-x-z}MnₓMg_{z}N : H_{y} (0.02 ≤ x ≤ 0.3, 0 < z ≤ 0.125, 0 < y - z < x in the case of y > z, and 0 < y ≤ z in the case of y ≤ z). This is because, in the case of a hydrogen concentration y as the donor being higher than a Mg concentration z as the acceptor, namely in the case of y > z, (y - z) represents the number of effective donors, when (y - z) is larger than x, the impurity band is fully occupied, and absorption does not occur on two or more stages.

The GaN-based compound semiconductor in the present invention can absorb light on two or more stages through the impurity band, and has a peak or a tail of light absorption other than direct transition from the valence band to the conduction band of GaN. At the peak or the tail, the light absorption coefficient at least in the wavelength region of not longer than 1500 nm and not shorter than 300 nm is not lower than 1000 cm⁻¹. More preferably, the light absorption coefficient is not lower than 3000 cm⁻¹. Further preferably, even in the infrared ray region (800 to 2000 nm), the light absorption coefficient is not lower than 1000 cm⁻¹, and more preferably, not lower than 3000 cm⁻¹. As the reason for the GaN-based compound semiconductor in the present invention having high light absorption coefficient, the unoccupied state of the impurity band and the ground state of the electrons are well balanced, meaning that the possibility for transition itself is high, and indicating that higher conversion efficiency can be realized as the photoelectric conversion material. Herein, the light absorption coefficient indicates a percentage of absorption of light during traveling thereof in a unit length, and the unit is cm⁻¹_{.}

GaN has a bandgap of 3.4eV, and a photocurrent is not generated even by irradiation with light having a wavelength not shorter than visible light. As opposed to this, the GaN-based compound semiconductor in the present invention can form at least one or more intermediate bands by an impurity, and hence a photocurrent is generated even in the case of irradiation with light having a wavelength not shorter than the visible light.

The GaN-based compound semiconductor in the present invention can be manufactured by a MBE method using a nitrogen-atom containing gas, such as ammonia or hydrazine, as a nitrogen source. In the MBE method, the nitrogen-atom containing gas is introduced into a vacuum atmosphere, and while the nitrogen-atom containing gas is subjected to photodecomposition or thermal decomposition on the substrate or in the vicinity thereof, the substrate is irradiated with metal molecular beams of Ga and the 3d-transition metal, to make GaTN (T is the 3d-transition metal) grow. A concentration of the 3d-transition metal can be changed by adjustment of a temperature of the 3d-transition metal element cell at the time of film formation so as to adjust a supplied amount thereof.

Further, the GaN-based compound semiconductor in the present invention can also be manufactured by a high-frequency sputtering method. The film formation by sputtering allows a change in composition with ease, and is suitable for formation of a film with a large area, thereby being suitable for manufacturing of the GaN-based compound semiconductor in the present invention. In the sputtering method, a substrate and a GaN target are installed in a vacuum chamber, a mixed gas of nitrogen and argon is introduced thereinto to generate plasma by a high frequency, and the sputtered GaN is deposited on the substrate, to form a film. At this time, installing the 3d-transition metal chip on the GaN target can give a GaN-based compound semiconductor with part of Ga replaced by the 3d-transition metal. Further, a replacement amount can arbitrarily be adjusted by a method of changing an area, the number, or an arrangement of 3d-transition metal chips, or the like. Further, the GaN-based compound semiconductor produced by the sputtering method shows a microcrystal or amorphous-like structure.

A photoelectric conversion element can be produced, using the GaN-based compound semiconductor in the present invention. The photoelectric conversion element is an element that absorbs light energy to convert into electric energy, and includes a light receiving element such as an image pickup element or a photodiode, or a power generation element such as a solar cell. Since the light-absorbing material in the present invention can absorb light energy in a broad-range wavelength region to convert into electric energy, it can realize high photoelectric conversion efficiency, and can be suitably used for the power generation element such as a solar cell. Moroever, it can be suitably used as a material for a light absorbing film of a solar heat power generator, a solar heat water heater, and the like.

Herein, a hole effect of Ga₁₋ₓMnₓN produced by the MBE method was measured by a Van der Pauw method, to indicate p-type conductivity and find a carrier concentration of 2 × 10²⁰/cm³ at the time of x being 0.068.

Meanwhile, similarly, the hole effect measurement was performed by the Van der Pauw method on a GaN-based film (GaTN) with part of Ga replaced by the 3d-transition metal, which had been produced by the sputtering method, to indicate n-type conductivity. It is to be noted that the reason for the change in conductivity type depending on the film forming method is unknown, but a cause thereof is currently under study.

As for GaMnN in the present invention, one produced by the MBE method has the wurtzite type structure, and one produced by the sputtering method has the microcrystal or amorphous mode. In the case of being produced by the MBE method, it has a similar lattice constant to that of GaN, and can form a pn-junction with lattice matching. For example, making Ga₁₋ₓMnₓN (hereinafter referred to as GaMnN) in the present invention grow by the MBE method on an n-GaN film can form a hetero pn-junction of p-GaMnN/n-GaN. Alternatively, forming on a p-GaN substrate a film of GaTN with part of Ga replaced by the 3d-transition metal by sputtering can form a hetero pn-junction of p-GaN/n-GaTN. Further, it can also form a double hetero pin-junction of p-GaN/GaTN/n-GaN (Herein, since GaTN used in the present invention is not an intrinsic insulating matter in a strict sense, representing it as i (pin structure) is not exactly correct, and representing it as a (pan structure) is correct since it is an absorber, but in the present invention, it is represented as the pin structure for the sake of structural easiness to understand). Moreover, since the acceptor dopant is implanted to obtain p-GaMn and the donor dopant is implanted to obtain n-GaMnN, photoelectric conversion elements with various structures can be realized.

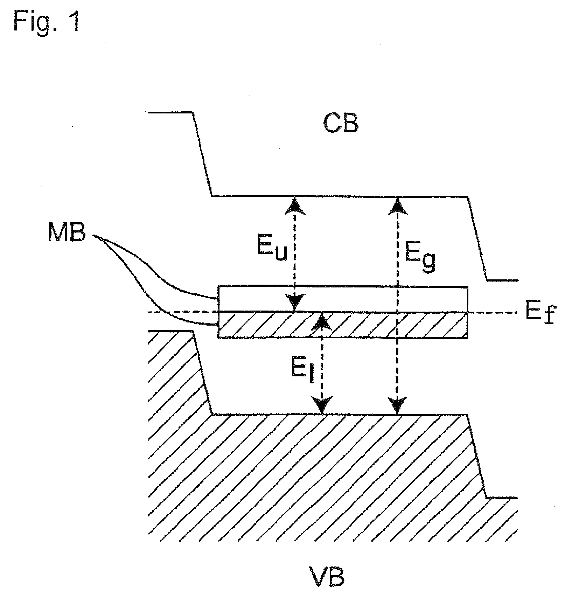

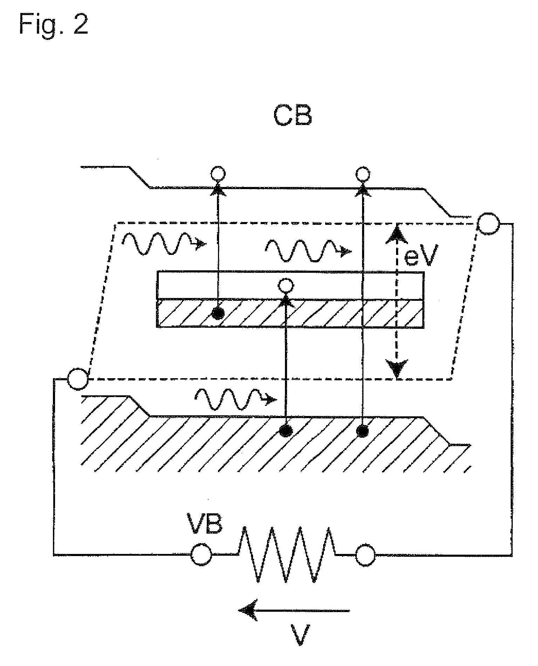

FIG. 1 is a schematic view showing an example of a band structure of a photoelectric conversion element having a p-GaN/GaMnN/n-GaN type configuration. Further, FIG. 2 is a schematic view showing an example of a band structure at the time of operation of the photoelectric conversion element. In the figures, VB denotes a valence band, CB denotes a conduction band, MB denotes an intermediate band made up of an impurity band, E_{g} denotes a band gap of GaN, E_{f} denotes a Fermi level, Eᵤ denotes a band gap between the impurity band and the conduction band, and Eₗ denotes a band gap between the valence band and the impurity band. This shows that, by light irradiation, electrons are excited from the valence band to the impurity band, and there are generated excitation (2) of electrons are generated from the valence band from the valence band to an unoccupied portion of the impurity band, and excitation (1) of electrons from the unoccupied portion of the impurity band to the conduction band.

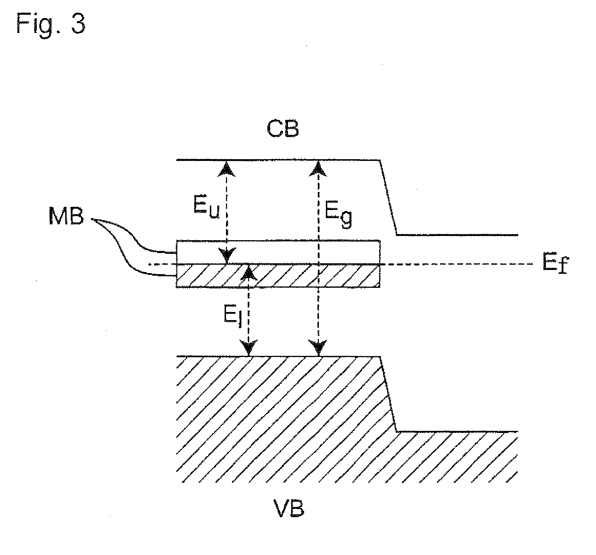

Meanwhile, FIG. 3 is a schematic view showing an example of a band structure having a p-GaMnN/n-GaN type configuration. The meanings of the reference signs are the same as those in FIG. 1. In this element as well, similarly to FIG. 1, excitation of the electrons are also generated by a channel other than that from the valence band to the conduction band.

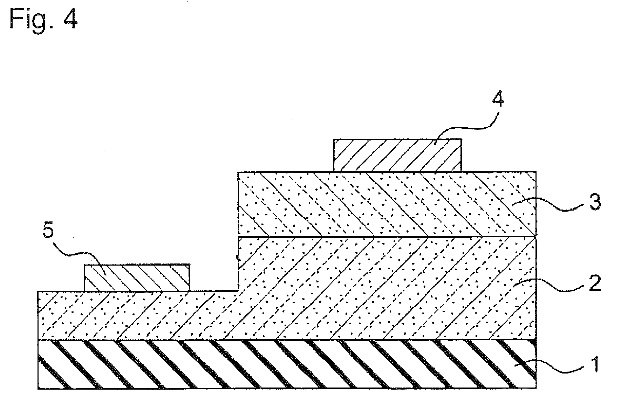

FIG. 4 is a schematic view showing an example of a structure of a solar cell using the light-absorbing material in the present invention. It is structured such that an n-GaN layer 2 and a p-GaMnN layer 3 are sequentially formed on a sapphire substrate 1, an electrode 4 is formed on the p-GaMnN layer 3, and an electrode 5 is provided on the n-GaN layer 2, part of which is exposed.

Sapphire has a small refraction index, and its band gap is a deep ultraviolet region, and sunlight can thus transmit through sapphire. Therefore, the sunlight is allowed to be incident from the sapphire substrate. Herein, a reflection preventing structure can also be formed on the incident surface of the sapphire substrate.

Further, rugged structure is preferably formed on the surface and/or the interface of the GaMnN layer 3. Accordingly, a ratio of light absorption can be increased to further improve the conversion efficiency. The degree of the ruggedness, when represented by surface average roughness, is preferably not smaller than the order of 0.5 µm.

Hereinafter, the present invention will be further described in detail by use of examples, but the present invention is not limited to the following examples.

### Example 1

### (Production of Ga₁₋ₓMnₓN film)

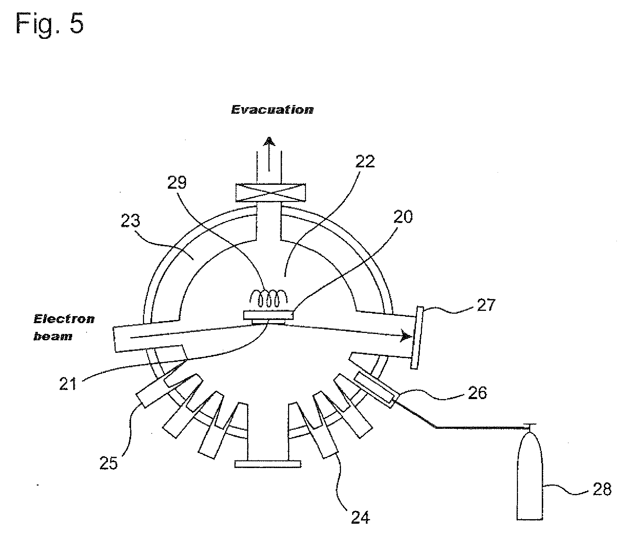

A Ga₁₋ₓMnₓN film was produced using an MBE device shown in FIG. 5. This device has a vacuum chamber 22, and on the bottom wall side thereof, a gas introduction nozzle 26 that introduces an ammonia gas from a gas source 28, a first vapor deposition source 24, and a second vapor deposition source 25 are arranged. On the ceiling side of the vacuum chamber 22, a heater 29 is arranged. Inside the first and second vapor deposition sources, a first metal material mainly composed of Ga and a second metal material mainly composed of Mn are respectively arranged. Here, 21 denotes a substrate (sapphire, silicon, quartz, GaN, or the like can be used for the substrate, but sapphire substrate is used in this case), and 20 denotes a substrate holder. The substrate surface is irradiated with an electron beam, and it reaches a RHEED screen 27. Moreover, 23 denotes a liquid nitrogen shroud for cooling.

After electrification of the heater to generate heat, the sapphire substrate is heated to 950°C to perform purification treatment, a temperature of the sapphire substrate was lowered to 550°C, an ammonia gas was ejected from a gas nozzle, to be sprayed on the sapphire substrate, while the first metal material inside the first vapor deposition source was heated to generate a metal molecular beam mainly composed of Ga, and the sapphire substrate surface was irradiated, thereby forming a buffer layer made up of a GaN thin film.

After formation of the buffer layer with a predetermined film thickness (0.2 µm), the temperature of the sapphire substrate was raised to 720°C, and a nitrogen-atom containing gas (ammonia gas, in this case) was directly sprayed on the buffer layer surface by the gas nozzle, to be thermally decomposed, while the first and second metal materials inside the first and second vapor deposition sources were heated to respectively generate a molecular beam mainly composed of Ga and a molecular beam mainly composed of Mn, and the buffer layer was irradiated, thereby to form a GaMnN thin film on the buffer layer surface. The GaMnN film with a thickness of 1 µm was formed on the condition that the temperature of the first vapor deposition source was 850°C, the temperature of the second vapor deposition source was 630°C, and a flow rate of the ammonia gas was 5 sccm.

A concentration of Mn in the obtained Ga₁₋ₓMnₓN film was measured by an electron probe microanalyzer (EPMA), to find that x was 0.082.

### (Crystal structure analysis)

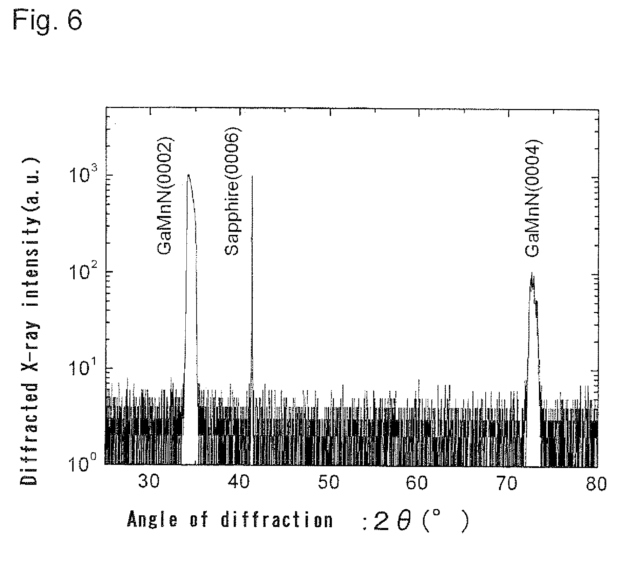

An X-ray diffraction pattern of the GaMnN film produced by the MBE method was measured using a thin-film X-ray diffraction device (X'part, manufactured by Philips Electronics Japan, Ltd.). FIG. 6 shows a result thereof. A reflection peak was observed in the vicinity of 34.5 degrees as in the case of wurtzite type GaN, and thus found to be the wurtzite type.

### (Measurement of light absorption spectrum)

A light absorption spectrum was measured using a UV-visible spectrophotometer (UV-3600 and SOLID Spec-3700, manufactured by Shimadzu Corporation).

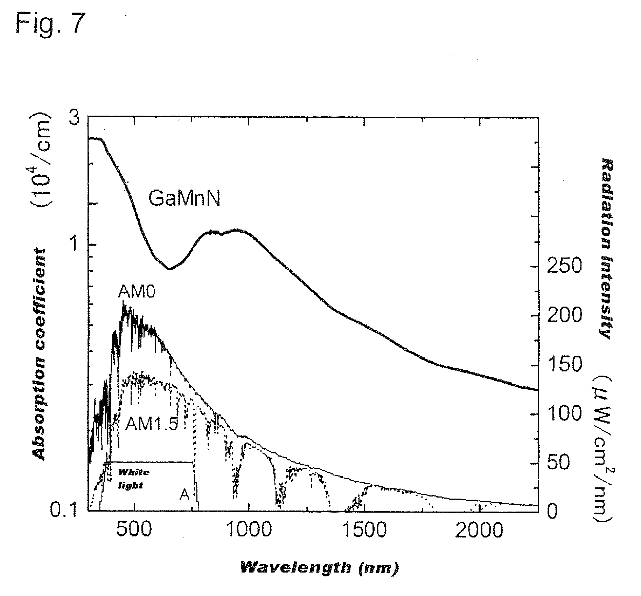

FIG. 7 shows an example of a light absorption spectrum of the Ga₁₋ₓMnₓN film (x = 0.082) in the present invention. Further, for the sake of reference, the figure shows a radiant intensity spectrum (AM 0 on the orbit of the earth, AM 1.5 on the earth's surface) of sunlight, and a radiant intensity spectrum of a white light source (MAX-302, manufactured by Asahi Spectra Co., Ltd.). GaN does not show absorption in the wavelength region of 400 nm to 2000 nm, whereas the Ga₁₋ₓMnₓN film has an absorption coefficient of not lower than 8000 cm⁻¹ in the wavelength region of 400 to 1000 nm. Further, it also has higher absorption than GaN in the ultraviolet and infrared regions. Absorption by the impurity band is recognized in a broad peak structure in the region of 1500 to 700 nm and a continuous absorption structure in the region of 700 to 400 nm. Moreover, as obvious from FIG. 7, the light absorption spectrum of the Ga₁₋ₓMnₓN film roughly corresponds to the radiation intensity spectrum of sunlight in terms of the wavelength region, and unused light in sunlight can thus be effectively used.

### (Measurement of photoconductivity)

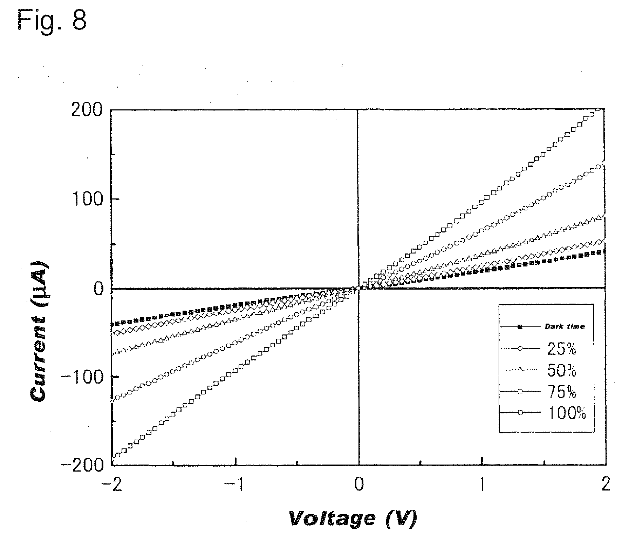

Using the white light source (wavelength of 400 to 750 nm) shown in FIG. 7, photoconductivity of the Ga₁₋ₓMnₓN film was measured. A voltage was applied to a pair of Ni/Au electrode evaporated on the Ga₁₋ₓMnₓN film to perform current measurement under light irradiation. FIG. 8 is a graph showing the relation between an output of a light source and a current value. In the figure, dark time refers to a state not irradiated with white light. Further, the light output was measured while it was increased in stages from 25% to 100% of its maximal output. The current value increased with increase in output of the light source, and a correlation between the light intensity and the generated current was recognized. Since the band gap of GaN corresponds to 365 nm and GaN is not excited by this white light source, this current is generated by formation of an impurity band of Ga₁₋ₓMnₓN.

### (Measurement of recombination time)

Recombination time of the Ga₁₋ₓMnₓN film was measured using a time-resolved photocurrent measuring method. The measuring method includes forming a pair of Ni-electrodes on the Ga₁₋ₓMnₓN film, connecting an ammeter, measuring a change in current with time after light irradiation for fixed time, and measuring the time until the current returns to the value before the light irradiation, and in the present invention, this value was defined as recombination time. A result thereof was 200 seconds.

### Example 2

### (Production of Ga₁₋ₓMnₓN film)

A Ga₁₋ₓMnₓN film was produced in a similar manner to Example 1 except that a supplied amount of Mn was controlled by adjustment of a cell temperature of Mn at the time of film formation. The film thickness was 0.4 µm, and x was 0.05.

### (Result)

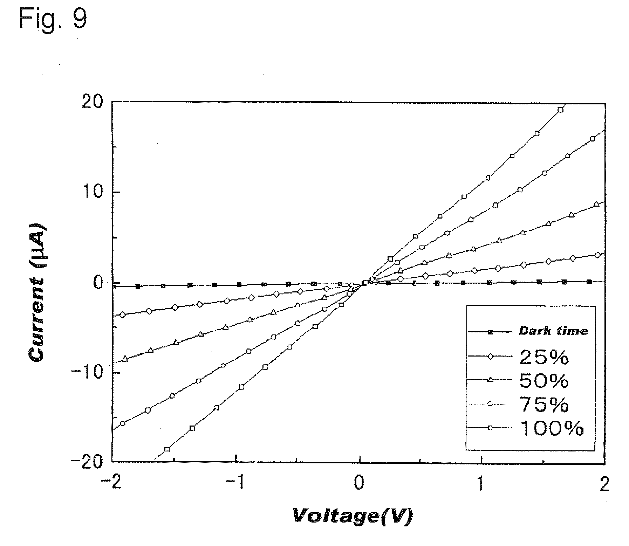

Photoconductivity was measured in a similar manner to Example 1. FIG. 9 shows a result thereof. It is found that the current value increases along with the intensity of the irradiated light. With the wavelength of the white light source being from 400 to 750 nm, direct transition (365 nm) from the valence band to the conduction band of GaN does not occur. This increase in current value is attributed to that light with 400 to 750 nm was absorbed into the impurity band of Ga₁₋ₓMnₓN to form carriers.

The light absorption coefficient was not lower than 1000 cm⁻¹ in the wavelength region of 300 to 1500 nm. Further, recombination time exceeding 0.01 second was obtained.

### Example 3

### (Production of Ga_{1-x-z}MnₓMg_{z}N film)

A Ga_{1-x-z}MnₓMg_{z}N film was produced in a similar manner to Example 2 except that Mg was supplied simultaneously with Ga and Mn at the time of production. The film thickness was 0.4 µm, x was 0.05, and z was 0.02.

### (Result)

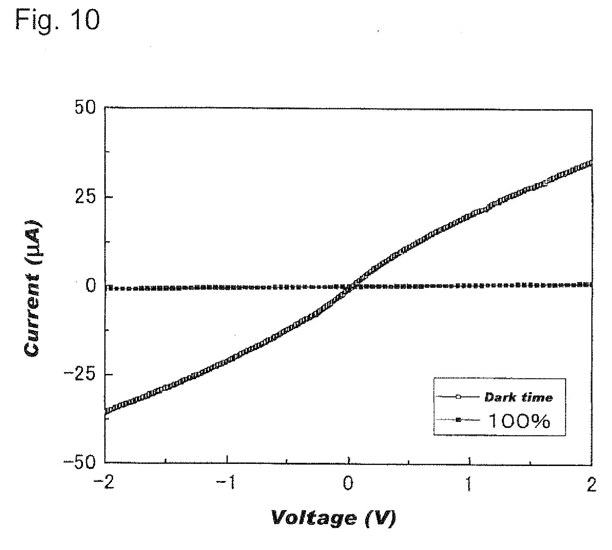

FIG. 10 is a graph showing the relation between the output of the light source and the current value. As a result, the current value increased at the time of light irradiation. Since the band gap of GaN corresponds to 365 nm and GaN is not excited by this white light source, this current is generated due to an impurity band of Ga_{1-x-z}MnₓMg_{z}N.

The light absorption coefficient was not lower than 1000 cm⁻¹ in the wavelength region of 300 to 1500 nm. Further, recombination time exceeding 0.01 second was obtained.

### Example 4

### (Production of Ga₁₋ₓMnₓN : H_{y} film)

A Ga₁₋ₓMnₓMg_{z}N : H_{y} film was produced in a similar manner to Example 1 except that, in producing a Ga₁₋ₓMnₓMg_{z}N film, a substrate temperature was set to a value as low as the order of 600°C to partially suppress decomposition of ammonia, so as to make hydrogen remain. Further, as for a Ga₁₋ₓMnₓN film, produced at a high substrate temperature of not lower than 700°C to cause hydrogen not to remain, hydrogen molecules were thermally decomposed by a hot filament method in a hydrogen atmosphere and the Ga₁₋ₓMnₓN film was irradiated, to produce Ga₁₋ₓMnₓN : H_{y}. The film thickness was 0.3 µm, x was 0.06, and y was 0.03.

### (Result)

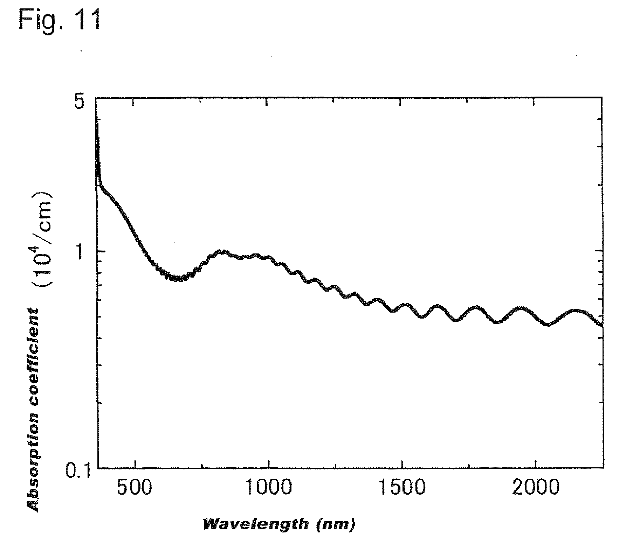

FIG. 11 shows a light absorption spectrum. The ₓMnₓN : H_{y} film has an absorption coefficient of not lower than 7000 cm⁻¹ in the wavelength region of 400 to 1000 nm, and an absorption coefficient of not lower than 1000 cm⁻¹ in the wavelength region of 300 to 1500 nm. Further, it also has higher absorption than GaN in the ultraviolet and infrared regions. Absorption by the impurity band was recognized in a broad peak structure in the region of 1500 to 700 nm and a continuous absorption structure in the region of 700 to 400 nm.

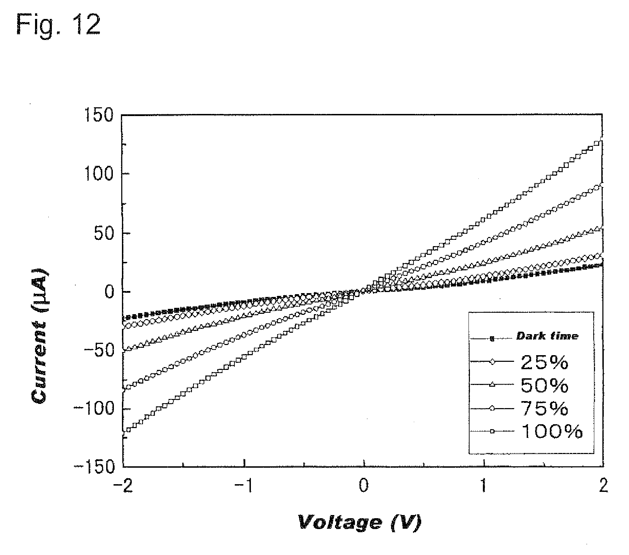

FIG. 12 is a graph showing the relation between the output of the light source and the current value. The current value increased with increase in output of the light source. Since the band gap of GaN corresponds to 365 nm and GaN is not excited by this white light source, this current is generated due to an impurity band of Ga₁₋ₓMnₓN: H_{y}.

Moreover, recombination time exceeding 0.01 second was obtained.

### Example 5

### (Influence of surface roughness of Ga₁₋ₓMnₓN film

### (Production of Ga₁₋ₓMnₓN film)

Three kinds of Ga₁₋ₓMnₓN films with different surface roughness were produced by the following method.

The production method controlled a nucleus generation density at the start of the growth of the Ga₁₋ₓMnₓN film, to promote three-dimensional growth. Alternatively, there can be used a method of making a supplied amount of ammonia during the growth smaller to promote three-dimensional growth.

### (Measurement of surface roughness)

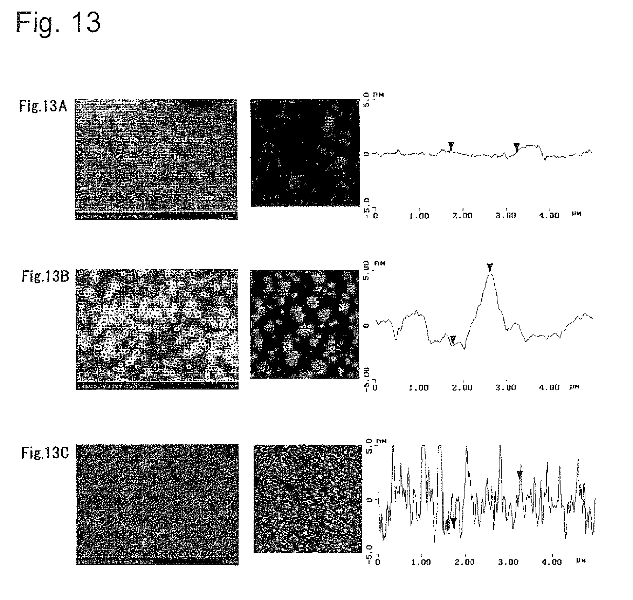

The surface roughness was measured using an atomic force microscope (AFM) manufactured by Digital Instruments, Inc. based on linear analysis of a height of an AFM image. Samples with different surface roughness were produced in the following method. A temperature of the Ga₁₋ₓMnₓN film at the start of the growth thereof is changed to control the nucleus generation density, and the temperature during the growth thereof is further controlled, so as to promote three-dimensional growth. FIGS. 13A, 13B, and 13C respectively show AFM photographs and measurement results of surface roughness of Samples 1 to 3. An average surface roughness was 0.2 nm in Sample 1, 0.6 nm in Sample 2, and 1.0 nm in Sample 3.

### (Result)

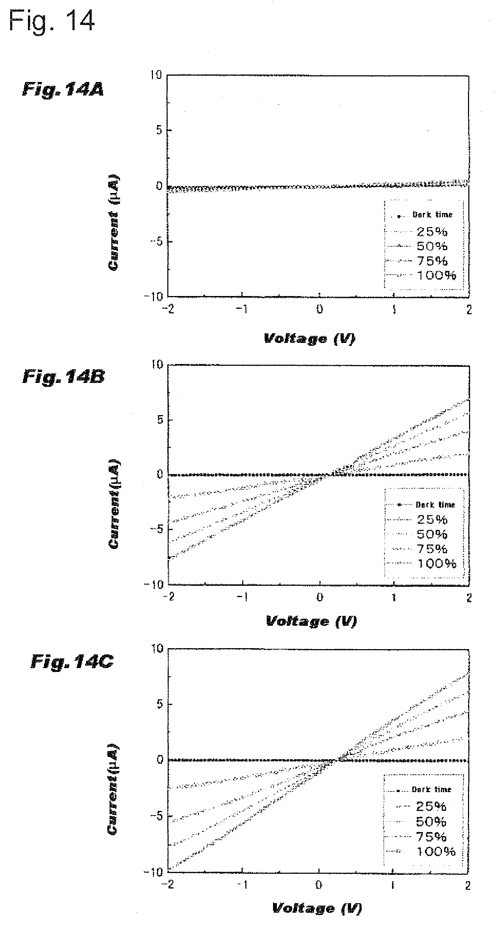

FIG. 14 is a graph showing the relation between the output of the light source and the current value. A large photocurrent was generated in Sample 2 and Sample 3 each having large average surface roughness as compared with Sample 1 having a flat surface. Therefore, increasing the average surface roughness can further improve the conversion efficiency.

### Example 6

### (Production of pin element)

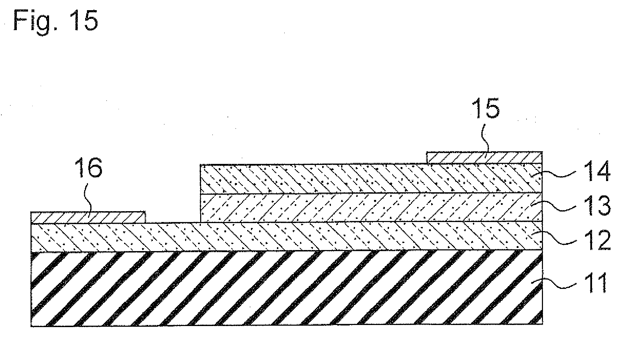

Although sapphire, silicon, quartz, GaN, or the like can be used as the substrate, the p-GaN layer 12 previously formed on the single-crystal sapphire substrate 11 was adopted here as the substrate, to produce a sample in FIG. 15. The GaMnN layer 13 and the n-GaN layer 14 placed thereon were formed on the substrate by MBE. As for the replacement amount of Mn, x is about 0.08 estimated from the supplied amount of Mn at the time of film formation. A film formation technique was as follows: first, part of the p-GaN layer 12 was covered by a metal mask, the GaMnN layer 13 was formed, and the n-GaN layer 14 was then formed. After the film formation, In was formed on each of the p-GaN layer 12 and part of the surface of the n-GaN layer 14 as electrodes 15, 16.

### (Result)

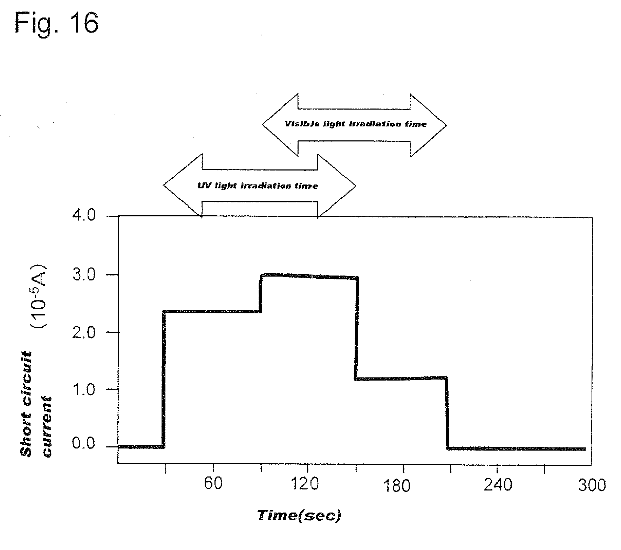

FIG. 16 shows changes in photocurrent sequentially observed at the time of the sample being irradiated with light beams of only ultraviolet light, the ultraviolet light and visible light, and only the visible light. The current is not allowed to flow between the In electrodes in the state of no irradiation with light, but the current is generated upon irradiation with the ultraviolet light, and this current increased when the visible light is superimposed for irradiation. Thereafter, when the irradiation with the ultraviolet light was stopped and irradiation only with the visible light was thus made, the current value becomes lower than in the case of irradiation only with the ultraviolet light, but the current continuously keeps being generated.

From this result, with the configuration using the GaMnN layer as the i-layer of the pin-junction, a photocurrent which is not generated in GaN is observed by irradiation only with the visible light, thus indicating that power has been generated. Further, from the increase in photocurrent upon superimposition of the ultraviolet light and the visible light, it has become apparent that a broad wavelength region of sunlight can be efficiently used than the element having the pin structure formed with GaN taken as the i layer.

### Example 7

### (Production by sputtering method)

Next, a GaN-based compound semiconductor was produced by the sputtering method. Here, p-GaN or n-GaN, formed on monocrystal sapphire as the substrate, was installed inside a vacuum chamber of a high frequency sputter apparatus, and as opposed to this, a GaN target is installed. A 3d-transition metal chip to replace Ga was installed on the target. The added amount was adjusted here by changing the number of chips. A heater for substrate heating is installed on the back surface of a holder for holding the substrate. After air was once exhausted from the inside of the chamber, a mixed gas of Ar-N₂ was introduced, and after the substrate was heated to a predetermined temperature, high-frequency power was applied to excite plasma, so as to perform sputtered film formation for predetermined time. Further, prior to the film formation by sputtering, the substrate and the target may be cleaned in the plasma.

Principal conditions for the sputtered film formation are shown below:
RF power: 200W
Substrate temperature: 300°C
Mixed ratio of Ar : N₂: 2 : 1
Film formation speed: 11 nm/min

### (Composition analysis)

The obtained Ga₁₋ₓTₓN film was a dense film having flatness and few defects regardless of addition or no addition of the 3d-transition metal. Composition analysis on a GaN-based compound semiconductor film produced by the sputtering method was performed by Rutherford backscattering spectrometry, to obtain x in Ga₁₋ₓTₓN.

A result of the analysis showed, from analyzed amounts of Ga and the 3d-transition metal and an analyzed amount of nitrogen, that the thin film has become a thin film having a non-stoichiometric composition. Hence there is a possibility that in part of the 3d-transition metal element, a Ga position has not been replaced, but a detail thereof is currently under study.

### (Result)

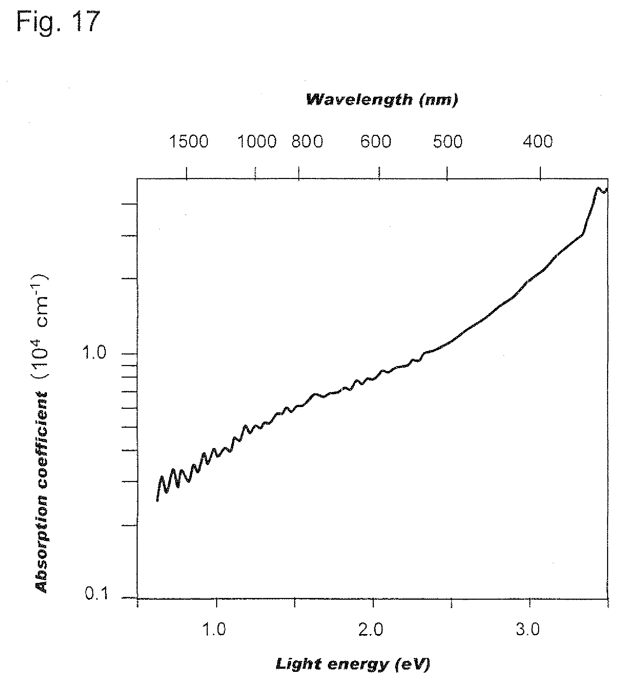

A light absorption spectrum of the thin film formed by the sputtering method was measured. FIGS. 17 to 20 show measurement results of light absorption spectrums of samples with Ga in GaN replaced by a variety of 3d-transition metals. FIG. 17 is a light absorption spectrum of a sample with its 3d-transition metal being V and x = 0.056, having a tail of absorption on a longer-wavelength side than 3.3 eV and having a broad peak of absorption in the vicinity of 1.5 eV. An absorption coefficient in the wavelength of 300 to 1500 nm is not lower than 3000 cm⁻¹.

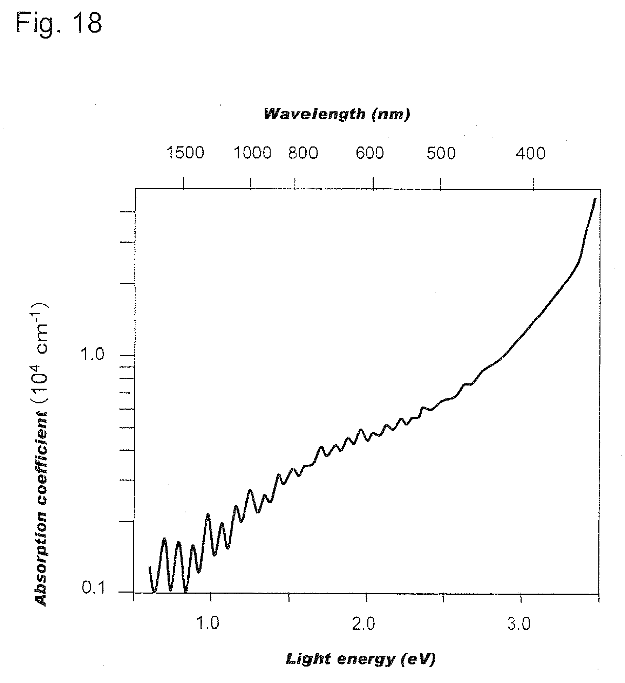

FIG. 18 is a light absorption spectrum of a sample with its 3d-transition metal being Cr and x = 0.088, having a tail of absorption on a longer-wavelength side than 3.3 eV and having a broad peak of absorption in the vicinity of 1.5 to 2.0 eV. The absorption coefficient in the wavelength of 300 to 1500 nm is not lower than 1000 cm⁻¹.

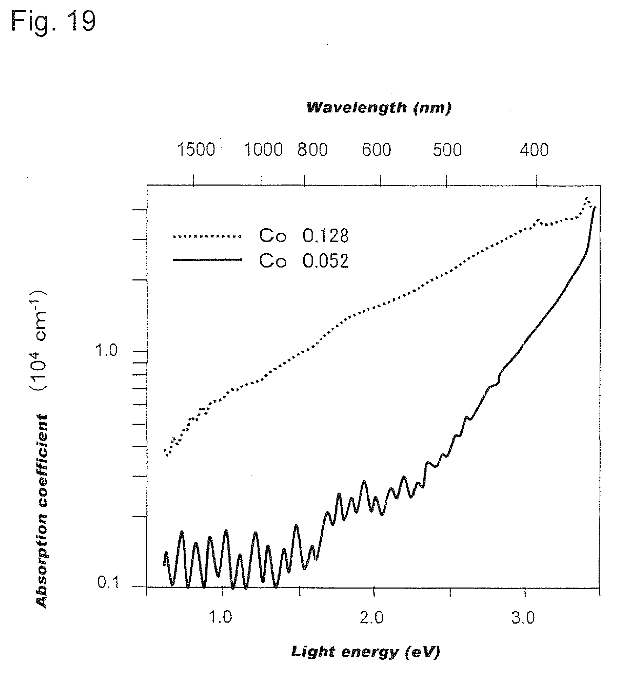

FIG. 19 is a light absorption spectrum of a sample with its 3d-transition metal being Co and x = 0.052, having a tail of absorption on a longer-wavelength side than 3.3 eV, and the absorption coefficient in the wavelength of 300 to 1500 nm is not lower than 1000 cm⁻¹. Similarly, a sample with x = 0.128 has a high tail of the absorption coefficient and has a peak in the vicinity of 1.7 eV, and the absorption coefficient in 300 to 1500 nm is not lower than 3000 cm⁻¹.

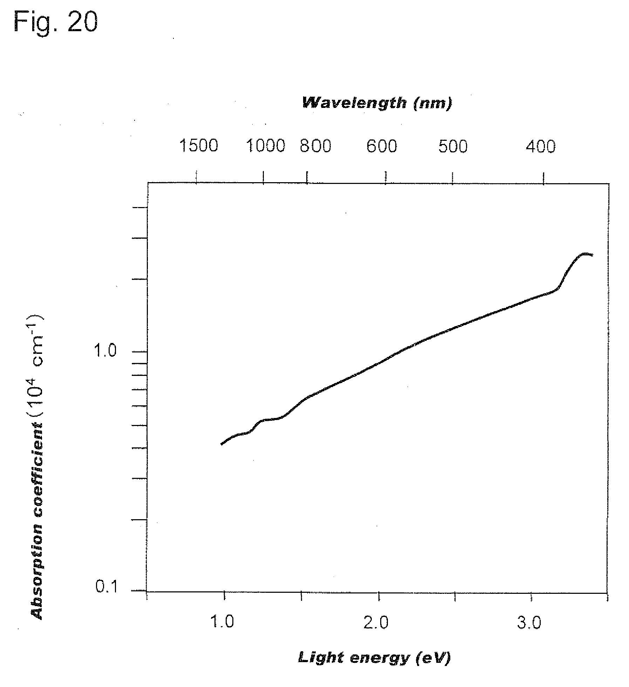

FIG. 20 is a light absorption spectrum of a sample with its 3d-transition metal being Mn and x = 0.2, having a high tail of the absorption coefficient on a longer-wavelength side than 3.3 eV, and the absorption coefficient in 300 to 1500 nm is not lower than 5000 cm⁻¹. As shown in FIG. 7, the sample produced by the MBE method had a clear absorption peak in the vicinity of 1.5 eV, whereas the sample produced by the sputtering method does not have a clear peak observed although having a high absorption coefficient. The cause of this has not been made clear, and although it is assumed that the sample produced by the MBE method has relatively high crystallinity, whereas the sample produced by the sputtering method has low crystallinity and forms a plurality of energy levels in the band gap in place of forming an impurity band, which is currently under study.

### Example 8

### (Power generation characteristics of element)

### (Production of pn-junction element)

The pn-junction element was produced by the sputtering method in the following manner. First, using p-GaN previously formed on a monocrystal sapphire as a substrate, a GaMnN layer is formed thereon. An Mn-amount x is 0.2. It was shown by the Van der Pauw method that the formed GaMnN layer has n-type electric conductivity. In the method for sputtered film production, part of the substrate surface was covered by a metal mask to form, on the substrate, a non-film formation section where no sputtered film is produced. After the sputtered film formation, with Ni used as a base, Au was evaporated onto part of the GaMnN layer and non-film formation section, to respectively form an n-layer electrode and a p-layer electrode.

### (Result)

Both electrodes of the pn-junction element were connected to a potentiostat, and while a bias voltage of -3 to +3 V was applied, a current flowing between both electrodes was measured. The measurements were performed both in the case of not performing irradiation with white light and in the case of performing the irradiation. When this element was irradiated with white light, a voltage as high as about 2.0 V as an open-end voltage was observed.

Similarly, in a pn-junction element using a GaCoN layer with a Co concentration x of 0.05, 0.13 instead of the GaMnN layer, a voltage as high as about 1.8 V as an open-end voltage was similarly observed.

### Industrial Applicability

A light-absorbing material in the present invention is capable of absorbing sunlight in a broad wavelength region, whereby it can be used for a photoelectric conversion element such as a solar cell, heat utilization of sunlight, and a light-absorbing element such as an optical filter that absorbs light in a broad range of a wavelength band.

## Claims

1. A light-absorbing material comprising a GaN-based compound semiconductor with part of Ga replaced by at least one kind of 3d transition metals, the GaN-based compound semiconductor having one or more impurity bands between a valence band and a conduction band, and whose light absorption coefficient over an overall wavelength region of not longer than 1500 nm and not shorter than 300 being not lower than 1000 cm⁻¹.

2. The light-absorbing material according to claim 1 , wherein the 3d-transition metal is Sc, Ti, V, Cr, Mn, Fe, Co, Ni, or Cu.

3. The light-absorbing material according to claim 1, wherein the 3d-transition metal is Mn, and wherein, when a replacement amount x of Mn is represented by Ga₁₋ₓMnₓN, a range of x is 0.02 ≤ x ≤ 0.3.

4. A light-absorbing material comprising a GaN-based compound semiconductor with part of Ga replaced by at least one kind of 3d transition metals and with an acceptor dopant and/or a donor dopant doped thereinto, the GaN-based compound semiconductor having one or more impurity bands between a valence band and a conduction band, and whose light absorption coefficient over an overall wavelength region of not longer than 1500 nm and not shorter than 300 nm being not lower than 1000 cm⁻¹.

5. The light-absorbing material according to claim 4, wherein the acceptor dopant is Mg, and wherein the GaN-based compound semiconductor is represented by a general formula Ga_{1-x-z}MnₓMg_{z}N (0.02 ≤ x ≤ 0.3, 0 < z ≤ 0.125).

6. The light-absorbing material according to claim 4, wherein the donor dopant is a hydrogen atom, and wherein the GaN-based compound semiconductor is represented by a general formula Ga₁₋ₓMnₓN : H_{y}(0.02 ≤ x ≤ 0.3, 0 < y < x).

7. The light-absorbing material according to claim 4, wherein the acceptor dopant and the donor dopant are respectively Mg and H, and wherein the GaN-based compound semiconductor is represented by a general formula Ga_{1-x-z}MnₓMg_{z}N : H_{y} (0.02 ≤ x ≤ 0.3, 0 < z ≤ 0.125, 0 <y-z<x in the case of y > z, and 0 < y ≤ z in the case of y ≤ z).

8. A photoelectric conversion element comprising a photoelectric conversion layer comprising at least one pn-junction or pin-junction formed by a plurality of compound semiconductor layers,
wherein at least one layer of the plurality of compound semiconductor layers is formed by use of a light-absorbing material comprising a GaN-based compound semiconductor with part of Ga replaced by at least one kind of 3d transition metals, and the GaN-based compound semiconductor has one or more impurity bands between a valence band and a conduction band, and whose light absorption coefficient over an overall wavelength region of not longer than 1500 nm and not shorter than 300 nm is not lower than 1000 cm⁻¹.

9. The photoelectric conversion element according to claim 8, wherein the GaN-based compound semiconductor is Ga₁₋ₓMnₓN (0.02 ≤ x ≤ 0.3).

10. A photoelectric conversion element comprising a photoelectric conversion layer comprising at least one pn-junction or pin-junction formed by a plurality of compound semiconductor layers,
wherein at least one layer of the plurality of compound semiconductor layers is formed by use of a light-absorbing material comprising a GaN-based compound semiconductor with part of Ga replaced by at least one kind of 3d transition metals, and with an acceptor dopant and/or a donor dopant doped thereinto, and the GaN-based compound semiconductor has one or more impurity bands between a valence band and a conduction band, and whose light absorption coefficient over an overall wavelength region of not longer than 1500 nm and not shorter than 300 nm is not lower than 1000 cm⁻¹.

11. The photoelectric conversion element according to claim 10, wherein the acceptor dopant is Mg, and wherein the GaN-based compound semiconductor is represented by a general formula Ga_{1-x-z}MnₓMg_{z}N (0.02 ≤ x ≤ 0.3, 0 < z ≤ 0.125).

12. The photoelectric conversion element according to claim 10, wherein the donor dopant is a hydrogen atom, and wherein the GaN-based compound semiconductor is represented by a general formula Ga₁₋ₓMnₓN : H_{y}(0.02 ≤ x ≤ 0.3, 0 < y < x).

13. The photoelectric conversion element according to claim 10, wherein the acceptor dopant and the donor dopant are respectively Mg and H, and wherein the GaN-based compound semiconductor is represented by a general formula Ga_{1-x-z}MnₓMg_{z}N : H_{y} (0.02 ≤ x ≤ 0.3, 0 < z ≤ 0.125, 0 < y - z < x in the case of y>z, and 0 < y ≤ z in the case of y ≤ z).

14. The photoelectric conversion element according to any one of claims 8 to 13, wherein a rugged structure is formed on a surface and/or an interface of the GaN-based compound semiconductor.
